# EUROPEAN PATENT SPECIFICATION

(11) **EP 1 482 241 B1**
(45) Date of publication and mention of the grant of the patent: **04.06.2008**
(21) Application number: 04012085.9
(22) Date of filing: 21.05.2004
(51) Int. Cl.: F21V 23/00, H01R 24/00, H01R 43/00, H05B 33/00, H05B 33/08, B60Q 1/26, H01L 25/00

(54) **A vehicle lighting device and method of assembling a vehicle lighting device**
Fahrzeugbeleuchtung und Verfahren zur Montage
Appareil d'éclairage pour véhicules et procédé de montage

(30) Priority: 29.05.2003 JP 2003152724
(43) Date of publication of application: 01.12.2004
(73) Proprietor: Sumitomo Wiring Systems, Ltd., Yokkaichi-City, Mie, 510-8503 (JP)
(72) Inventor: Asao, Kazuhiro, c/o Sumitomo Wiring Systems, Ltd., Yokkaichi-city, Mie 510-8503 (JP); Niwa, Takashi, c/o Sumitomo Wiring Systems, Ltd., Yokkaichi-city, Mie 510-8503 (JP); Kitade, Takashi, c/o Sumitomo Wiring Systems, Ltd., Yokkaichi-city, Mie 510-8503 (JP)
(74) Representative: Müller-Boré & Partner Patentanwälte

(56) References cited:
- EP-A- 1 002 696
- US-A- 5 746 497
- US-B1- 6 371 636
- US-B1- 6 411 022

## Description

The present invention relates to a vehicle lighting device using a light emitting element such as a light emitting diode as a light source and to a method of assembling such a vehicle lighting device.

In recent years, the use of light emitting diodes (LEDs) has been proposed for some of vehicle lighting devices in place of electric bulbs such as base bulbs or wedge base bulbs as light sources (see, for example, Japanese Unexamined Patent Publication No. 2001-294079). On the other hand, in the case of using LEDs, lighting circuits in which resistors and diodes are disposed are necessary for luminance control and protection. Accordingly, it has been essential to additionally provide a printed circuit board with these lighting circuits.

However, in a prior art vehicle lighting device, resistors and diodes need to be soldered to a circuit pattern upon constructing the lighting circuits on the printed circuit board and this operation is cumbersome. The luminance of the LED can be adjusted, for example, by changing the capacity of the resistor (resistance value). However, since the resistors are soldered as described above, it is not easily exchangeable. It has been an actual situation that luminance cannot be substantially adjusted. Further, there are several other problems including the tendency of the printed circuit board itself to take up a large arrangement space. Thus, there has been an earnest demand for further improvements.
The use of insulation displacement for a vehicle lighting device is disclosed in EP-1002696.

The present invention was developed in view of the above problems and an object is to decrease production costs for such vehicle lighting devices.

This object is solved according to the invention by a vehicle lighting device according to claim 1 and by a method of assembling a vehicle lighting device according to claim 7. Preferred embodiments of the invention are suject of the dependent claims.

According to the invention, there is provided a vehicle lighting device provided with a light emitting element as a light source and constructed such that power is or can be applied to the light emitting element via a lighting circuit in which one or more control electronic or electric parts such as a resistor, a diode and the like are provided, wherein, on a base including at least one socket portion into which the light emitting element is mountable, one or more insulated wires are laid to form a specified (predetermined or predeterminable) circuit pattern and to be connected with the socket portion, and one or more control modules, preferably formed by resin-molding the electronic and/or electric parts, having one or more connection terminals of insulation-displacement type projecting therefrom are disposed and connected with the insulated wires at specified (predetermined or predeterminable) positions of the insulated wires by insulation displacement by means of the connection terminals, thereby forming the lighting circuit.

Since it is sufficient to press the one or more control modules into connection with the laid insulated wires in the case of forming the lighting circuit, the formation of the lighting circuit and the production of the lighting device can be made easier. For example, since a change in the number of connections of the control modules for one electric or electronic property (e.g. of resistors) can be easily changed and a change in another electric or electronic property (e.g. the capacity thereof) can be also easily made, the luminance of the light emitting element can be adjusted. This makes the use of a printed circuit board unnecessary and reduces a space used. Since the circuit pattern is formed by laying the one or more insulated wires and the one or more control modules are connected by insulation displacement, the circuit pattern and the connecting positions of the control modules can be easily changed, thereby improving a degree of freedom in designing the lighting circuit and enabling a change in specification to be easily dealt with.

According to a preferred embodiment of the invention, each control module is formed such that the connection terminal projects in a mounting direction or substantially down from a side surface of a main body.

As compared to a control module in which a connection terminal projects from the bottom or mating surface of a main body, the height of the control module(s) or that of the control module(s) on the base in the case of connecting the control module(s) with the insulated wire(s) by insulation displacement can be reduced, with the result that the height of the lighting device can be reduced.

Preferably, a socket portion into which at least one LED and/or at least one electric bulb is mountable is (preferably also) provided on the base.

Even in the case that the light emitting element is used only for some of a plurality of light sources as in a combination lamp, a change in the entire construction can be dealt with while being suppressed.

Further preferably, the connection terminal comprises one or more blades for cutting and/or displacing an insulation coating of the insulated wire.

Most preferably, one or more mount bases are provided on the base for mounting the control module(s).

According to the invention, there is further provided a method of assembling or mounting a vehicle lighting device, in particular according to the invention or a preferred embodiment thereof, comprising the following steps:
providing a base including a socket portion into which a light emitting element is (at least partly) mountable;
laying one or more insulated wires to form a specified (predetermined or predeterminable) circuit pattern and so as to be connected with the socket portion on the base; and
arranging one or more control modules having one or more connection terminals of insulation-displacement type projecting therefrom thereby connecting the control modules with the insulated wires at specified (predetermined or predeterminable) positions of the insulated wires by insulation displacement by means of the connection terminals, thereby forming the lighting circuit.

According to a preferred embodiment of the invention, the method further comprises a step of forming the control modules by resin-molding one or more electronic and/or electric parts such as a resistor, a diode or the like.
Preferably, each control module is formed such that the connection terminal projects in a mounting direction from a side surface of a main body. Further preferably, the method further comprises a step of providing a socket portion into which at least one LED and/or at least one electric bulb is mountable on the base.

Still further preferably, the connection terminal comprises one or more blades for cutting and/or displacing an insulation coating of the insulated wire.

Most preferably, the method further comprises a step of providing one or more mount bases on the base for mounting the control module(s).

These and other objects, features and advantages of the present invention will become more apparent upon reading of the following detailed description of preferred embodiments and accompanying drawings. It should be understood that even though embodiments are separately described, single features thereof may be combined to additional embodiments.
FIG. 1 is a plan view of a combination lamp according to a first embodiment of the invention,
FIG. 2 is a side view in section of the combination lamp,
FIG. 3 is a circuit construction diagram of a lighting circuit,
FIG. 4 is an exploded perspective view showing a resistor module and a connecting construction therefor,
FIG. 5 is a perspective view of a diode module,
FIG. 6 is a section showing an operation of pressing a control module into contact,
FIG. 7 is a section showing a state after the operation of FIG. 6 is completed,
FIG. 8 is a perspective view of a resistor module according to a second embodiment,
FIG. 9 is a perspective view of a diode module,
FIG. 10 is a plan view of a combination lamp, and
FIG. 11 is a side view in section of the combination lamp.

Hereinafter, preferred embodiments of the present invention are described with reference to the accompanying drawings.

### <First Embodiment>

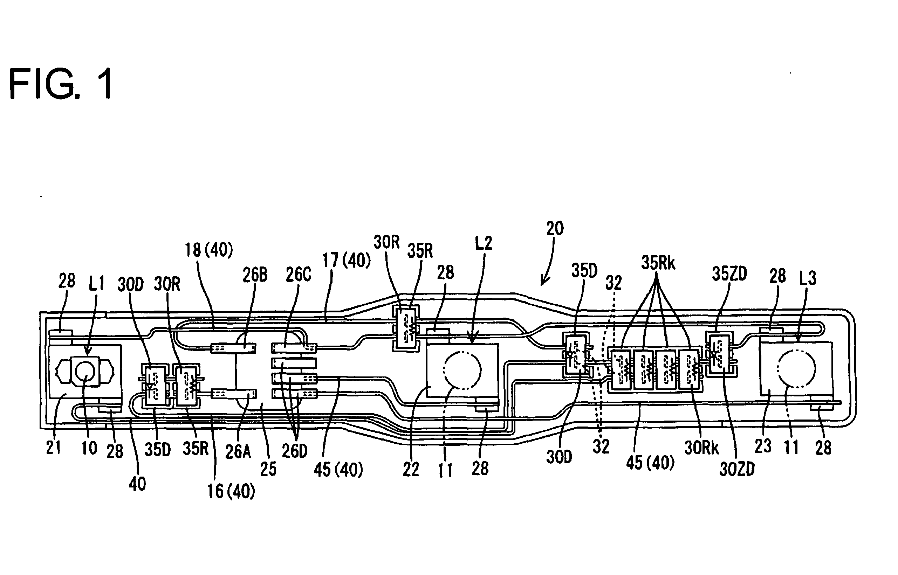

A first preferred embodiment of the present invention is described with reference to FIGS. 1 to 7.

In this embodiment is shown a rear combination lamp to be disposed at a rear part of a vehicle. For example, as shown in FIG. 1, the rear combination lamp is constructed such that a tail stop lamp L1 which also serves as a side lamp and turns on upon a braking operation, a backup lamp L2 which turns on when the vehicle is shifted into reverse gear, and a rear turn signal lamp L3 are arranged preferably substantially in a row while being spaced apart.

One or more light emitting diodes 10 (hereinafter, merely "LED") are used in the tail stop lamp L1, and one or more (preferably wedge base) bulbs 11 (hereinafter, merely "bulbs") are used in the backup lamp L2 and the rear turn signal lamp L3.

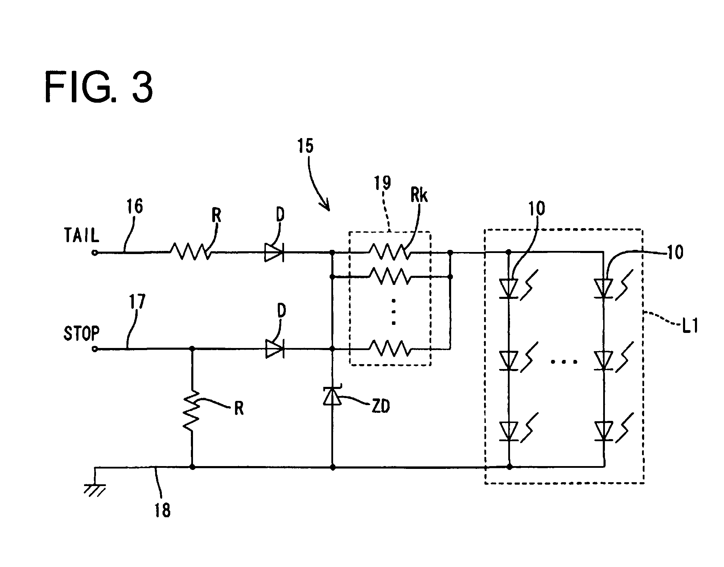

As shown in FIG. 3, a plurality of LEDs 10 are used in the tail stop lamp L1 and a lighting circuit 15 is provided therefor as shown in FIG. 3. It should be noted that the number of the LEDs 10 is arbitrarily set.

The lighting circuit 15 is provided with a tail-side input line 16 and a stop-side input line 17, the LEDs 10 are connected between the input lines 16, 17 and a ground line 18, and a luminance adjuster 19 including a plurality of resistors Rk for luminance adjustment is provided in the lighting circuit 15. Besides, resistors R, diodes D, a zener diode ZD are connected at specified positions for protection or other purpose.

A current of a specified (predetermined or predeterminable) value is constantly applied to the tail-side input line 16, for example, at night, whereby the LEDs 10 are turned on at a relatively low luminance in order to function as a tail lamp. When braking is applied while the LEDs 10 are on, a current of a value several time as large as the current applied to the tail-side input line 16 is applied to the stop-side input line 17, whereby the LEDs 10 are turned on at a high luminance in order to function as a stop lamp. Here, the luminance of the LEDs 10 can be adjusted by the total resistance value of the resistors Rk provided in the luminance adjuster 19.

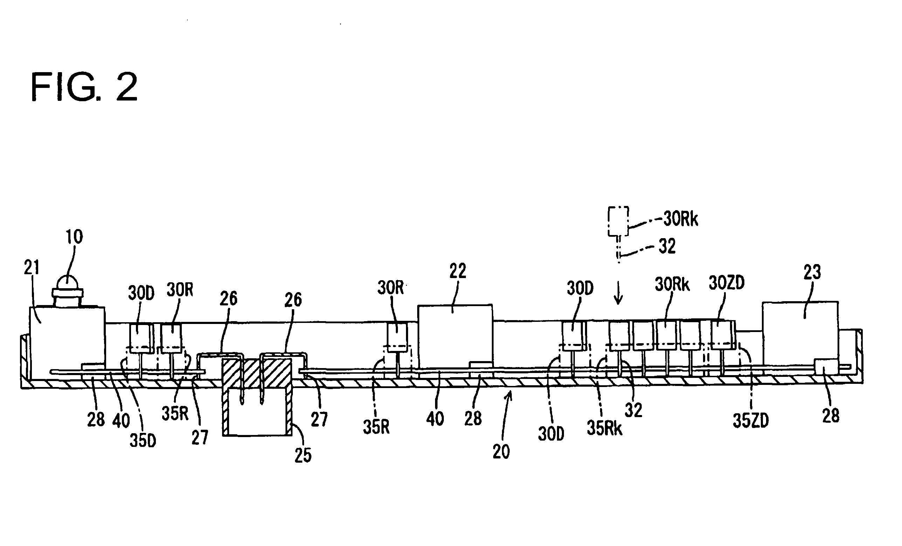

The construction of the vehicle lighting device is specifically described. The lighting device of this embodiment includes a socket base 20. This socket base 20 is made e.g. of a synthetic resin material and in the form of a shallow and narrow saucer as a whole as shown in FIGS. 1 and 2.

This socket base 20 is formed with a first socket portion 21 used to mount the LEDs 10 as the tail stop lamp L1, and a second and a third socket portions 22, 23 used to mount the bulb 11 as the backup lamp L2 and the bulb 11 as the rear turn signal lamp L3 in this order from one side (left side).

In order to construct the aforementioned lighting circuit 15 for the LEDs 10, a connector portion 25 having a substantially open lateral (bottom) surface is provided between the first and second socket portions 21, 22 and a connector connected with an unillustrated power-supply wire can be at least partly fittable thereinto. A tail-side input terminal 26A and a stop-side input terminal 26B are mounted at one side of the connector portion 25, and a ground terminal 26C and other (e.g. three) input terminals 26D are mounted at the other side. One end of each terminal 26 is located in an opening of the connector portion 25 as shown in FIG. 2. Further, at least one blade 27 is formed at the other end of each terminal 26.

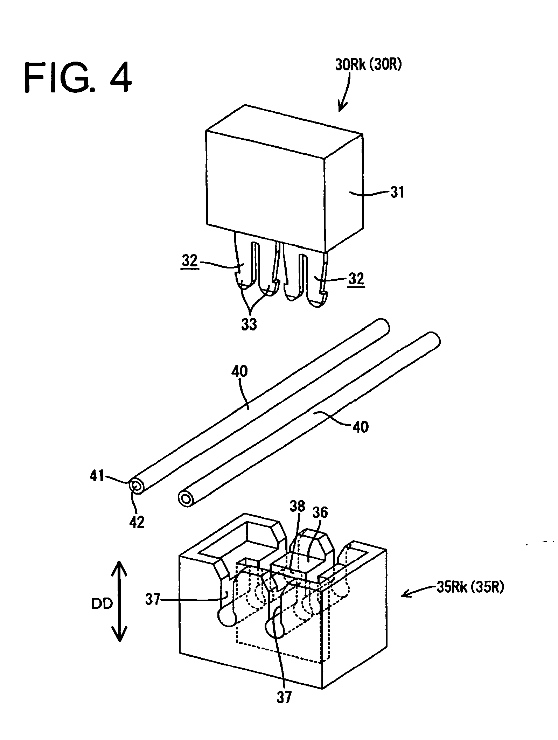

The resistors Rk for luminance adjustment and the resistors R, the diodes D and the zener diode ZD for protection or other purpose, which are arranged in the lighting circuit 15, are preferably formed into modules. For example, the resistors Rk for luminance adjustment are embedded in (preferably substantially block-shaped) main bodies 31 by molding as shown in FIG. 4, thereby forming resistor modules 30 Rk for luminance adjustment. One or more, preferably a pair of lead terminals 32 project (preferably substantially side by side) from the engagement surface or bottom surface of the main body 31 of each resistor module 30Rk, and are formed preferably by insulation-displacement terminals provided with one or more blades 33.

Similarly, the resistors R, the diodes D and the zener diode ZD for protection or other purpose are also formed into resistor modules 30R, diode modules 30D, and a zener diode module 30ZD by molding, and a pair of lead terminals 32 formed by insulation-displacement terminals project from the bottom surface of each main body 31.

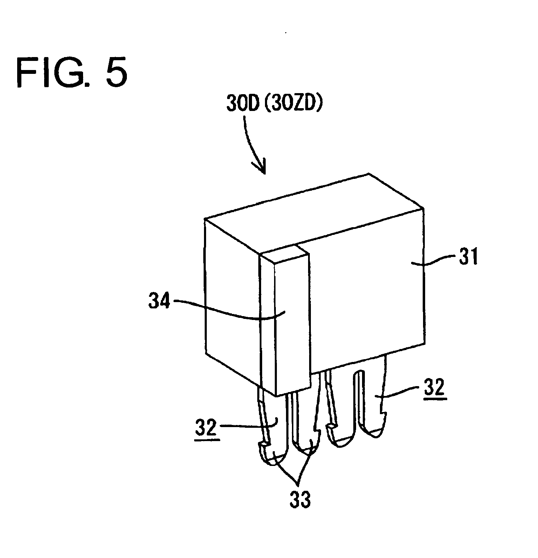

In the diode modules 30D and the zener diode module 30ZD, a positioning rib 34 preferably is formed at (preferably an end of) one surface of each main body 31 as shown in FIG. 5 in order to stabilize an inserting posture into a mount base 35. In the case of collectively naming the respective modules 30Rk, 30R, 30D and 30ZD, they are called control modules 30.

On the other hand, one or more, e.g. four mount bases 35 into which the resistor modules 30Rk for luminance adjustment are to be at least partly mounted are formed preferably substantially side by side between the second socket portion 22 and the third socket portion 23 in the above socket base 20. A mount base 35D for the diode module 30D and a mount base 35ZD for the zener diode module 30ZD are formed at the lateral (left and right) sides of these mount bases 35Rk. Further, a mount base 35R for the resistor module 30R is formed at the left side of the second socket portion 22, and the mount base 35D for the diode module 30D and the mount base 35R for the resistor module 30R are formed substantially side by side at the lateral (right) side of the first socket portion 21.

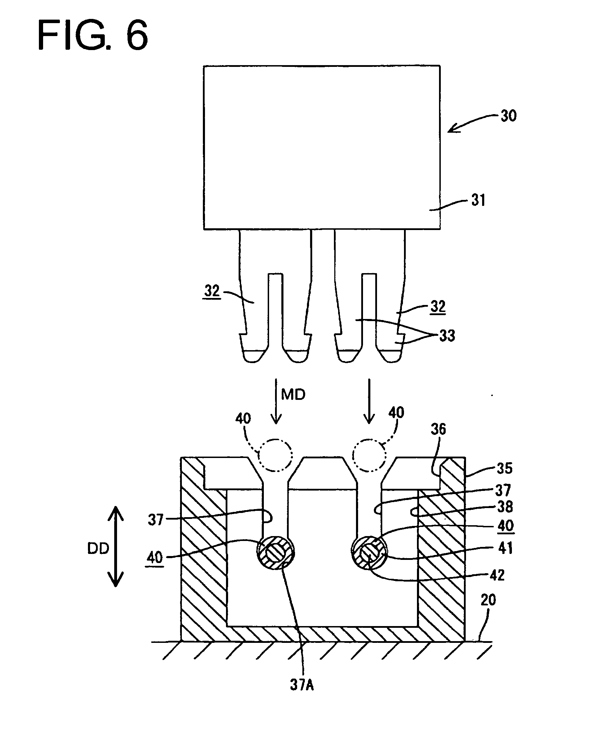

As shown in FIGS. 4 and 6, an engaging recess 36 into which the bottom end of the main body 31 of the aforementioned control module 30 is at least partly fitted or fittable or insertable is formed in the upper or mating surface of each of these mount bases 35, and one or more, e.g. two accommodating grooves 37 for respective insulated wires 40 are so formed preferably substantially in parallel as to extend between two longer surfaces. These accommodating grooves 37 are formed to extend from the upper surface to an intermediate position (preferably to a substantially middle position) with respect to depth direction DD, and the insulated wires 40 are so at least partly accommodated in bottom portions 37A as not to come out as shown in FIG. 6. Preferably, the bottom portions 37a have a width which is slightly wider than an inserting side of the accommodating groove 37 (see e.g. FIG. 6) so that the insulated wire 40 can be securely held therein. An insertion groove 38 into which the lead terminals 32 of the control module 30 are at least partly insertable is formed to be at an angle different from 0° or 180°, preferably substantially normal to the two accommodating grooves 37 in an intermediate portion (preferably substantially a widthwise middle part).

Each of the first, second and third socket portions 21, 22, 23 has preferably a pair of connecting portions 28 formed preferably substantially on the opposite surfaces thereof. Although not shown in detail, insulation-displacement terminals connected with the mounted LEDs 10 or bulb 11 are at least partly accommodated into these connecting portions 28, and the insulated wires 40 are at least partly inserted into these insulation-displacement terminals to be electrically connected therewith.

Next, one example of assembling procedure is described.

In order to form the lighting circuit 15, the insulated wires 40 having lengths corresponding to the tail-side input line 16, the stop-side input line 17, the ground line 18, and other necessary connecting lines are prepared. As shown in FIG. 1, these insulated wires 40 are laid in a specific (predetermined or predeterminable) circuit pattern from the first socket portion 21 and the respective mount bases 35 to the connector portion 25. The insulated wires 40 to be connected with the first socket portion 21 are pressed into the connecting portions 28 to be connected with the insulation-displacement terminals, and ends of the insulated wire 40 as the tail-side input line 16 and the insulated wire 40 as the stop-side input line 17 are to be respectively connected with the tail-side input terminal 26A and the stop-side input terminal 26B, and the insulated wire 40 as the ground line 18 is to be connected with the ground terminal 26C at its intermediate position by insulation displacement.

Further, the insulated wires 40 laid in the respective mount bases 35 are pushed into the accommodating grooves 37 to be at least partly accommodated in the bottom portions 37A as shown in FIG. 6.

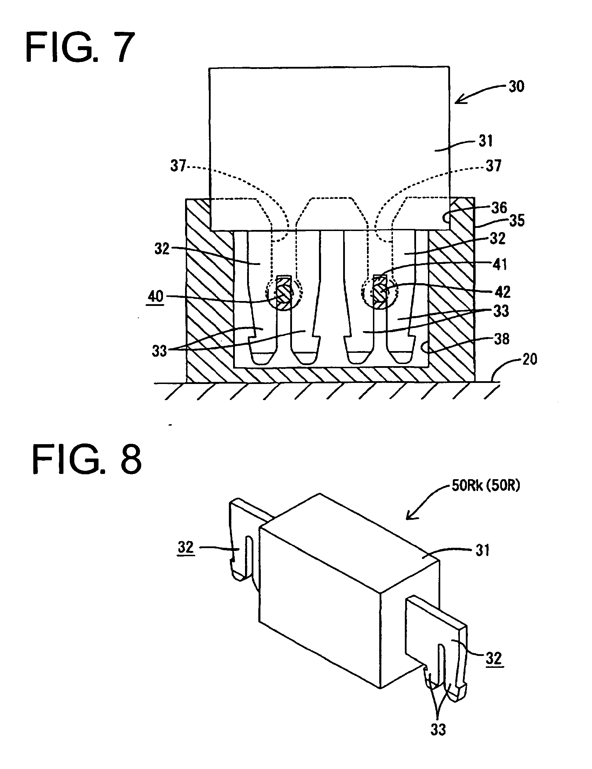

After the insulated wires 40 are laid, the respective control modules 30 are mounted into the corresponding mount bases 35. When the control module 30 is mounted into the mount base 35 in a mounting direction MD (as indicated by arrows in FIG. 6), the lead terminals 32 are at least partly inserted into the insertion groove 38. During the insertion, insulation coatings 41 of the insulated wires 40 are at least partly cut or displaced by the blades 33. When the control module 30 is substantially properly mounted as shown in FIG. 7, the blades 33 come into contact with cores 42 of the insulated wires 40, i.e. the respective lead terminals 32 of the control module 30 are electrically connected with the corresponding insulated wires 40 preferably by insulation displacement.

Finally, the lighting circuit 15 is completed by mounting the one or more LEDs 10 into the first socket 21, and the LEDs 10 can be controllably turned on and off by at least partly fitting the connector connected with the power supply wire into the connector portion 25. Here, in the case of adjusting the luminance of the LEDs 10, the number of the resistor modules 30Rk for luminance adjustment may be changed or a plurality of kinds of resistor modules 30Rk in which the resistors Rk having different (total) resistance values are embedded may be prepared and suitably selectively mounted. In short, the luminance of the LEDs 10 can be adjusted by changing the total resistance value of the resistors Rk in the luminance adjuster 19.

The second and third socket portions 22, 23 for the bulbs 11 are connected with the corresponding input terminals 26D via other connection lines 45 likewise made of the insulated wires 40. The ground line 18 of the lighting circuit 15 for the LEDs 10 is or can be also used as a ground line. If the bulbs 11 are at least partly mounted into both socket portions 22, 23, the bulbs 11 can be also controllably turned on and off as a result of connection with the connector connected with the power-supply wire.

This embodiment can have many advantages as follows.

In the case of forming the lighting circuit 15 for the LEDs 10 in which electronic or electric parts such as the resistors Rk, R, it is sufficient to prepare the diodes D and the zener diodes ZD are provided, the control modules 30 having the respective electronic or electric parts at least partly embedded therein while the insulated wires 40 are laid in a specified (predetermined or predeterminable) circuit pattern and to connect these control modules 30 with the insulated wires 40 preferably by insulation displacement as the control modules 30 are at least partly mounted into the corresponding mount bases 35. Thus, as compared to conventional cases where the electronic or electric parts are soldered, the lighting circuit 15 can be more easily formed, which leads to the efficient production of a lighting device within a shorter period.

Since the control modules 30 are connected with the insulated wires 40 preferably by insulation displacement, a change in the number of connection of the resistor modules 30Rk for luminance adjustment, a change in the capacity (resistance value) of the resistor modules 30Rk and/or other changes in the circuitry or the like can be easily made, with the result that the luminance of the LEDs 10 can be adjusted.

Since the printed circuit board is not necessary, a space used can be made smaller.

The circuit pattern is formed by laying the insulated wires 40 and the control modules 30 are connected preferably by insulation displacement. Thus, the connecting positions of the circuit pattern and the control modules 30 can be easily changed, thereby improving a degree of freedom in designing the lighting circuit 15 and enabling a change in specification to be easily dealt with.

Further, even in the case that the LEDs 10 are used only for some of a plurality of light sources as in the combination lamp, it can be dealt with while maximally suppressing a change in the entire construction by, for example, forming the lighting circuit 15 using a dead space on a socket base 20.

Accordingly, to simplify production and improve a degree of freedom in designing, one or more LEDs 10 are used as a tail stop lamp L1. A socket portion 21 for the LEDs 10 is provided at the lateral (left) end of a socket base 20, and a lighting circuit 15 for the LEDs 10 including the socket 21 and a connector portion 25 is constructed on or at or in the socket base 20. Thus, electronic parts such as resistors for luminance adjustment are formed into control modules 30 preferably by molding. Lead terminals 32 of the respective control modules 30 are formed preferably by insulation-displacement terminals. On the other hand, insulated wires 40 are laid through mount bases 35 in a specified (predetermined or predeterminable) circuit pattern on the socket base 20. When the control modules 30 are at least partly mounted into the corresponding mount bases 35, the lead terminals 32 are or can be at least partly pressed into connection to form the lighting circuit.

### <Second Embodiment>

Next, a second preferred embodiment of the present invention is described with reference to FIGS. 8 to 11.

In the second preferred embodiment, the shape of the control modules is changed. In the following description, only differences to the first preferred embodiment are mainly described and no repetitive description is given on parts having similar or the same functions as in the first preferred embodiment by suitably identifying them by the same reference numerals.

The resistors Rk for luminance adjustment and the resistors R, the diodes D and/or the zener diode ZD for protection or other purpose which are provided in the lighting circuit 15 are at least partly formed into modules preferably by molding. Each of resistor modules 50Rk for luminance adjustment and a resistor module 50R is, as shown in FIG. 8, formed such that one or more, preferably a pair of lead terminals 32 preferably made of insulation-displacement terminals provided with one or more blades 33 project down from the substantially opposite or different side surfaces of a (preferably substantially block-shaped) main body 31.

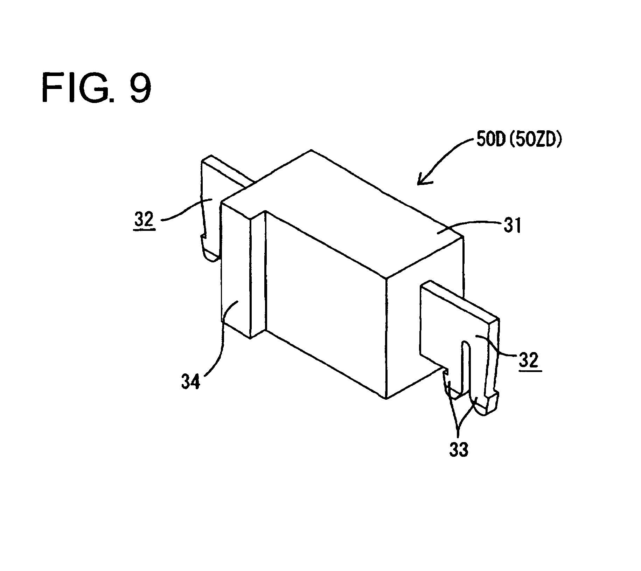

Each of diode modules 50D and a zener diode module 50ZD is also formed such that one or more, preferably a pair of lead terminals 32 preferably made of insulation-displacement terminals provided with one or more blades 33 project down from the substantially opposite or different side surfaces of a main body 31 as shown in FIG. 9. However, in the diode modules 50 and the zener diode module 50ZD, a positioning rib 34 is formed at (preferably an end of) one surface of the main body 31 in order to stabilize an inserting posture and/or guiding an at least partial insertion into a mount base 55 to be described later as shown in FIG. 9.

In other words, each control module 50 is formed as a so-called lateral control module having the preferred pair of lead terminals 32 on the substantially opposite side surfaces of the main body 31.

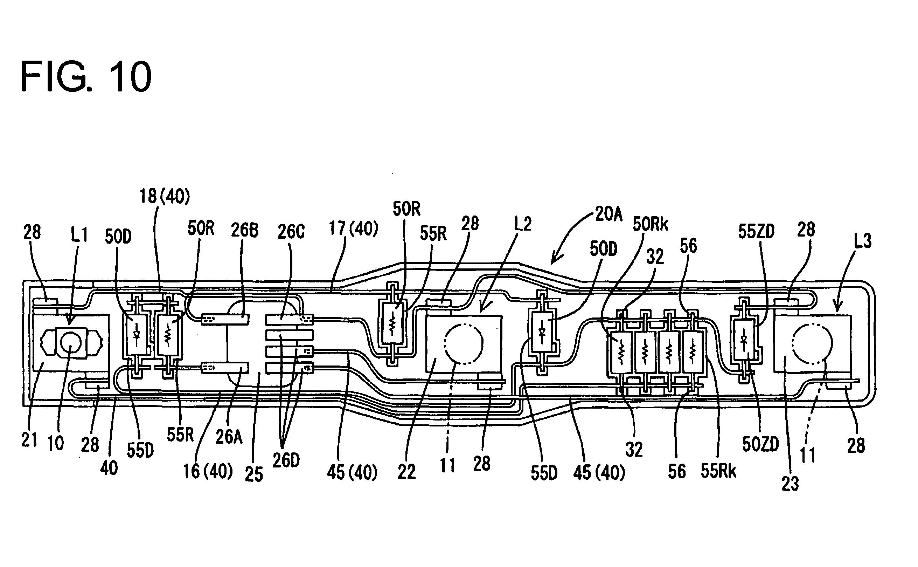

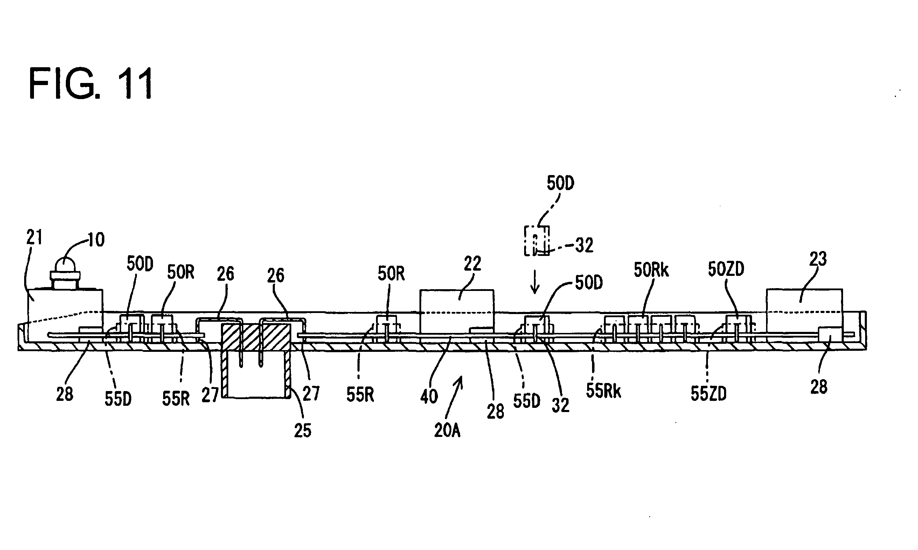

On the other hand, as shown in FIGS. 10 and 11, mount bases 55Rk, 55R, 55D and 55ZD into which the respective control modules 50 are at least partly mountable are formed on a socket base 20A substantially in the same arrangement as in the first embodiment. In the mount base 55 of the second embodiment, one or more receiving portions 56 into which the insulated wires 40 are at least partly insertable and with which the lead terminals 32 of the control module 50 can be pressed or at least partly inserted into contact are formed preferably on the substantially opposite side surfaces.

In this second embodiment, the insulated wires 40 are laid in a specified (predetermined or predeterminable) circuit pattern from the first socket portion 21 and the respective mount bases 55 (receiving portions 56) to the connector portion 25 as shown in FIG. 10. Thereafter, the lead terminals 32 of the respective control modules 50 are at least partly inserted into the receiving portions 56 of the corresponding mount bases 55 to be connected with the insulated wires 40 laid there preferably by insulation displacement.

In the second embodiment as well, the same functions and effects as those of the first embodiment can be obtained. In addition, since the control modules 55 are of the so-called lateral type in which the one or more lead terminals 32 project down from the side surface(s) of the main body 31 in the second embodiment, the height of the control modules 50 themselves and the height thereof on the socket base 20A in the case of connection with the insulated wires 40 preferably by insulation displacement can be suppressed. As a result, the height of the entire combination lamp can be made smaller.

### <Other Embodiments>

The present invention is not limited to the above described and illustrated embodiments. For example, the following embodiments are also embraced by the technical scope of the present invention as defined by the claims. Beside the following embodiments, various changes can be made without departing from the scope of the present invention as defined by the claims.
(1) The assembling procedures shown in the foregoing embodiments are merely examples and can be suitably changed.
(2) Although the LEDs are used only for one lamp of the rear combination lamp in the foregoing embodiments, they may be used for all the lamps.
(3) The present invention is applicable not only to combination lamps, but also to vehicle lighting devices provided with a single lighting device.

### LIST OF REFERENCE NUMERALS

- L1 ...: tail stop lamp
- 10 ...: LED (light emitting element)
- 11 ...: bulb (electric bulb)
- 15 ...: lighting circuit
- Rk, R ...: resistor (control electronic part)
- D ...: diode (control electronic part)
- ZD ...: zener diode (control electronic part)
- 20 ...: socket base (base)
- 20A ...: socket base (base)
- 21,22,23 ...: socket portion
- 25 ...: connector portion
- 28 ...: connecting portion
- 30Rk, 30R ...: resistor module (control module)
- 30D ...: diode module (control module)
- 30ZD ...: zener diode module (control module)
- 31 ...: main body
- 32 ...: lead terminal (connection terminal)
- 33 ...: blade
- 35Rk, 35R, 35D, 35ZD ...: mount base
- 37 ...: accommodating groove
- 38 ...: insertion groove
- 40 ...: insulated wire
- 50Rk, 50R ...: resistor module (control module)
- 50D ...: diode module (control module)
- 50ZD ...: zener diode module (control module)
- 55Rk, 55R, 55D, 55ZD ...: mount base
- 56 ...: receiving portion

## Claims

1. A vehicle lighting device provided with a light emitting element (10; 11) as a light source and constructed such that power is applied to the light emitting element (10; 11) via a lighting circuit in which one or more control electronic parts (Rk; R; D; ZD) such as a resistor, a diode or the like, but at least one resistor, are provided formed into control modules (30Rk; 30R; 30D; 30ZD; 50Rk; 50R; 50D; 50ZD), wherein, on a base (20; 20A) including a socket portion (21; 22; 23) into which the light emitting element (10; 11) is mountable, one or more insulated wires (40) are laid to form a specified circuit pattern and connected with the socket portion (21; 22; 23), and the control modules (30Rk; 30R; 30D; 30ZD; 50Rk; 50R; 50D; 50ZD) having one or more connection terminals (32) of insulation-displacement type projecting therefrom are to be disposed and connected with the insulated wires (40) at specified positions of the insulated wires (40) by insulation displacement by means of the connection terminals (32), thereby forming the lighting circuit, and whereby the luminance of the light emitting element (10;11) is adjustable by the total resistance value of the at least one resistor.

2. A vehicle lighting device according to claim 1, wherein the control modules (30Rk; 30R; 30D; 30ZD; 50Rk; 50R; 50D; 50ZD) are formed by resin-molding the electronic and/or electric parts (Rk; R; D; ZD).

3. A vehicle lighting device according to one or more of the preceding claims, wherein each control module (30Rk; 30R; 30D; 30ZD; 50Rk;. 50R; 50D; 50ZD) is formed such that the connection terminal (32) projects in a mounting direction (MD) from a side surface of a main body (31).

4. A vehicle lighting device according to one or more of the preceding claims, wherein a socket portion (21; 22; 23) into which at least one LED (10) and/or at least one electric bulb (11) is mountable is provided on the base (20; 20A).

5. A vehicle lighting device according to one or more of the preceding claims, wherein the connection terminal (32) comprises one or more blades (33) for cutting and/or displacing an insulation coating (41) of the insulated wire (40).

6. A vehicle lighting device according to one or more of the preceding claims, wherein one or more mount bases (35) are provided on the base (20; 20A) for mounting the control module(s) (30Rk; 30R; 30D; 30ZD; 50Rk; 50R; 50D; 50ZD).

7. A method of assembling a vehicle lighting device, comprising the following steps:
providing a base (20; 20A) including a socket portion (21; 22; 23) into which a light emitting element (10; 11) is mountable;
laying one or more insulated wires (40) to form a specified circuit pattern so as to be connected with the socket portion (21; 22; 23) on the base (20; 20A); and
arranging one or more control modules (30Rk; 30R; 30D; 30ZD; 50Rk; 50R; 50D; 50ZD) having one or more connection terminals (32) of insulation-displacement type projecting therefrom thereby connecting the control modules (30Rk; 30R; 30D; 30ZD; 50Rk; 50R; 50D; 50ZD) with the insulated wires (40) at specified positions of the insulated wires (40) by insulation displacement by means of the connection terminals (32), thereby forming the lighting circuit.

8. A method according to claim 7, further comprising a step of forming the control modules (30Rk; 30R; 30D; 30ZD; 50Rk; 50R; 50D; 50ZD) by resin-molding one or more electronic and/or electric parts (Rk; R; D; ZD) such as a resistor, a diode or the like, but at least one resistor.

9. A method according to claim 7 or 8, wherein each control module (30Rk; 30R; 30D; 30ZD; 50Rk; 50R; 50D; 50ZD) is formed such that the connection terminal (32) projects in a mounting direction (MD) from a side surface of a main body (31).

10. A method according to one or more of the preceding claims 7 to 9, further comprising a step of providing a socket portion (21; 22; 23) into which at least one LED (10) and/or at least one electric bulb (11) is mountable on the base (20; 20A).

## Patentansprüche

1. Fahrzeugbeleuchtung bzw. -beleuchtungsvorrichtung, welche mit einem Licht emittierenden Element (10; 11) als eine Lichtquelle versehen ist und derart konstruiert ist, daß Leistung an das Licht emittierende Element (10; 11) über eine Beleuchtungsschaltung angelegt ist bzw. wird, in welcher ein oder mehrere elektronische(s) Regel- bzw. Steuerteil(e) (Rk; R; D; ZD), wie beispielsweise ein Widerstand, eine Diode oder dgl., jedoch wenigstens ein Widerstand vorgesehen ist bzw. sind, welche(s) in Regel- bzw. Steuermodule (30Rk; 30R; 30D; 30ZD; 50Rk; 50R; 50D; 50ZD) ausgebildet ist bzw. sind, wobei auf einer Basis (20; 20A), welche einen Fassungs- bzw. Sockelabschnitt (21; 22; 23) beinhaltet, in welchen das Licht emittierende Element (10; 11) montierbar bzw. anordenbar ist, ein oder mehrere isolierte(r) Draht (Drähte) (40) gelegt ist bzw. sind, um ein bestimmtes Schaltungsmuster auszubilden, und mit dem Sockelabschnitt (21; 22; 23) verbunden ist bzw. sind, und die Regel- bzw. Steuermodule (30Rk; 30R; 30D; 30ZD; 50Rk; 50R; 50D; 50ZD), welche einen oder mehrere Verbindungsanschluß (-anschlüsse) (32) eines lsolationsverschiebungstyps aufweisen, welche(r) davon vorragt bzw. vorragen, anzuordnen und mit den isolierten Drähten (40) an bestimmten Positionen der isolierten Drähte (40) durch eine lsolationsverschiebung bzw. -verlagerung mittels der Verbindungsanschlüsse (32) zu verbinden sind, wodurch die Beleuchtungsschaltung gebildet ist, und wodurch die Leuchtdichte bzw. Luminanz des Licht emittierenden Elements (10; 11) durch den gesamten Widerstandswert des wenigstens einen Widerstands einstellbar ist.

2. Fahrzeugbeleuchtung nach Anspruch 1, wobei die Regel- bzw. Steuermodule (30Rk; 30R; 30D; 30ZD; 50Rk; 50R; 50D; 50ZD) durch ein Harzformen bzw. -gießen der elektronischen und/oder elektrischen Teile (Rk; R; D; ZD) ausgebildet sind.

3. Fahrzeugbeleuchtung nach einem oder mehreren der vorangehenden Ansprüche, wobei jedes Regel- bzw. Steuermodul (30Rk; 30R; 30D; 30ZD; 50Rk; 50R; 50D; 50ZD) derart ausgebildet ist, daß der Verbindungsanschluß (32) in einer Montagerichtung (MD) von einer Seitenoberfläche eines Hauptkörpers (31) vorragt.

4. Fahrzeugbeleuchtung nach einem oder mehreren der vorangehenden Ansprüche, wobei ein Sockelabschnitt (21; 22; 23), in welchen wenigstens eine LED (10) und/oder wenigstens eine elektrische Glühlampe (11) montierbar bzw. anordenbar ist bzw. sind, an der Basis (20; 20A) vorgesehen bzw. zur Verfügung gestellt ist.

5. Fahrzeugbeleuchtung nach einem oder mehreren der vorangehenden Ansprüche, wobei der Verbindungsanschluß (32) eine oder mehrere Klinge(n) bzw. Schneide(n) (33) für ein Schneiden und/oder Verlagern einer lsolationsbeschichtung (41) des isolierten Drahts (40) umfaßt.

6. Fahrzeugbeleuchtung nach einem oder mehreren der vorangehenden Ansprüche, wobei eine oder mehrere Montagebasis (-basen) (35) an der Basis (20; 20A) für ein Montieren bzw. Festlegen des (der) Regel- bzw. Steuermoduls (-module) (30Rk; 30R; 30D; 30ZD; 50Rk; 50R; 50D; 50ZD) vorgesehen ist bzw. sind.

7. Verfahren zum Montieren bzw. Zusammenbauen einer Fahrzeugbeleuchtung, umfassend die folgenden Schritte:
Bereitstellen einer Basis (20; 20A), welche einen Sockel- bzw. Fassungsabschnitt (21; 22; 23) beinhaltet, in welchen ein Licht emittierendes Element (10; 11) montierbar bzw. anordenbar ist;
Legen von einem oder mehreren isolierten Draht (Drähten) (40), um ein bestimmtes Schaltungsmuster auszubilden, um mit dem Sockelabschnitt (21; 22; 23) auf der Basis (20; 20A) verbunden zu werden; und
Anordnen von einem oder mehreren Regel- bzw. Steuermodul(en) (30Rk; 30R; 30D; 30ZD; 50Rk; 50R; 50D; 50ZD), welche(s) einen oder mehrere Verbindungsanschluß (-anschlüsse) (32) eines Isolationsverschiebungstyps aufweist bzw. aufweisen, welche(r) davon vorragt (vorragen), wodurch die Regel- bzw. Steuermodule (30Rk; 30R; 30D; 30ZD; 50Rk; 50R; 50D; 50ZD) mit den isolierten Drähten (40) an bestimmten Positionen der isolierten Drähte (40) durch eine Isolationsverschiebung bzw. -verlagerung mittels der Verbindungsanschlüsse (32) verbunden werden, wodurch die Beleuchtungsschaltung gebildet wird.

8. Verfahren nach Anspruch 7, weiterhin umfassend einen Schritt eines Ausbildens der Regel- bzw. Steuermodule (30Rk; 30R; 30D; 30ZD; 50Rk; 50R; 50D; 50ZD) durch ein Harzformen bzw. -gießen von einem oder mehreren elektronischen und/oder elektrischen Teil(en) (Rk; R; D; ZD), wie beispielsweise eines Widerstands, einer Diode oder dgl., jedoch wenigstens eines Widerstands.

9. Verfahren nach Anspruch 7 oder 8, wobei jedes Regel- bzw. Steuermodul (30Rk; 30R; 30D; 30ZD; 50Rk; 50R; 50D; 50ZD) derart gebildet wird, daß der Verbindungsanschluß (32) in einer Montagerichtung (MD) von einer Seitenoberfläche eines Hauptkörpers (31) vorragt.

10. Verfahren nach einem oder mehreren der vorangehenden Ansprüche 7 bis 9, weiterhin umfassend einen Schritt eines Bereitstellens eines Sockel- bzw. Fassungsabschnitts (21; 22; 23), in welchen wenigstens eine LED (10) und/oder wenigstens eine elektrische Glühlampe (11) auf der Basis (20; 20A) montierbar bzw. anordenbar ist bzw. sind.

## Revendications

1. Appareil d'éclairage pour véhicules comprenant un élément d'émission de lumière (10 ; 11) comme source de lumière et construit de sorte qu'une alimentation en énergie est appliquée à l'élément d'émission de lumière (10 ; 11) via un circuit d'éclairage dans lequel un ou plusieurs éléments électroniques de commande (Rk ; R ; D ; ZD) tels qu'une résistance, une diode ou analogue, mais au moins une résistance, sont prévus sous la forme de modules de commande (30Rk ; 30R ; 30D ; 30ZD ; 50Rk ; 50R ; 50D ; 50ZD), dans lequel, sur un socle (20 ; 20A) comportant une douille (21 ; 22 ; 23) dans laquelle l'élément d'émission de lumière (10 ; 11) peut être monté, un ou plusieurs fils isolés (40) sont posés de manière à former une configuration de circuit spécifiée et ils sont connectés à la douille (21 ; 22 ; 23), et les modules de commande (30Rk ; 30R ; 30D ; 30ZD ; 50Rk ; 50R ; 50D ; 50ZD) ayant une ou plusieurs bornes de connexion (32) du type à déplacement d'isolant en saillie doivent être disposés et connectés aux fils isolés (40) à des positions spécifiées des fils isolés (40) par déplacement d'isolant au moyen des bornes de connexion (32), formant ainsi le circuit d'éclairage, de sorte que la luminance de l'élément d'émission de lumière (10 ; 11) est réglable par la valeur de résistance totale de la dite au moins une résistance.

2. Appareil d'éclairage pour véhicules selon la revendication 1, dans lequel les modules de commande (30Rk ; 30R ; 30D ; 30ZD ; 50Rk ; 50R ; 50D ; 50ZD) sont formés par moulage dans une résine des composants électroniques et/ou électriques (Rk ; R ; D ; ZD).

3. Appareil d'éclairage pour véhicules selon une ou plusieurs des revendications précédentes, dans lequel chaque module de commande (30Rk ; 30R ; 30D ; 30ZD ; 50Rk ; 50R ; 50D ; 50ZD) est formé de sorte que la borne de connexion (32) fasse saillie dans une direction de montage (MD) à partir d'une surface latérale d'un corps principal (31).

4. Appareil d'éclairage pour véhicules selon une ou plusieurs des revendications précédentes, dans lequel une douille (21 ; 22 ; 23), dans laquelle au moins une DEL (10) et/ou au moins une ampoule électrique (11) peut être montée, est prévue sur le socle (20 ; 20A).

5. Appareil d'éclairage pour véhicules selon une ou plusieurs des revendications précédentes, dans lequel la borne de connexion (32) comprend une ou plusieurs lames (33) pour couper et/ou déplacer un revêtement isolant (41) du fil isolé (40).

6. Appareil d'éclairage pour véhicules selon une ou plusieurs des revendications précédentes, dans lequel une ou plusieurs bases de montage (35) sont prévues sur le socle (20 ; 20A) pour le montage du ou des modules de commande (30Rk ; 30R ; 30D ; 30ZD ; 50Rk ; 50R ; 50D ; 50ZD).

7. Procédé d'assemblage d'un appareil d'éclairage pour véhicules, comprenant les étapes suivantes :
préparation d'un socle (20 ; 20A) incluant une douille (21 ; 22 ; 23) dans laquelle un élément d'émission de lumière (10 ; 11) peut être monté ;
pose d'un ou plusieurs fils isolés (40), pour former une configuration de circuit spécifiée, de façon à être connectés à la douille (21 ; 22 ; 23) sur le socle (20 ; 20A) ; et
agencement d'un ou plusieurs modules de commande (30Rk ; 30R ; 30D ; 30ZD ; 50Rk ; 50R ; 50D ; 50ZD) ayant une ou plusieurs bornes de connexion (32) du type à déplacement d'isolant en saillie à partir des dits modules afin de connecter les modules de commande (30Rk ; 30R ; 30D ; 30ZD ; 50Rk ; 50R ; 50D ; 50ZD) avec les fils isolés (40) à des positions spécifiées des fils isolés (40) par déplacement d'isolant au moyen des bornes de connexion (32), formant ainsi le circuit d'éclairage.

8. Procédé selon la revendication 7, comprenant en outre une étape de formation des modules de commande (30Rk ; 30R ; 30D ; 30ZD ; 50Rk ; 50R ; 50D ; 50ZD) par moulage, dans une résine d'un ou plusieurs composants électroniques et/ou électriques (Rk ; R ; D ; ZD) tels qu'une résistance, une diode ou analogue, mais au moins une résistance.

9. Procédé selon la revendication 7 ou 8, dans lequel chaque module de commande (30Rk ; 30R ; 30D ; 30ZD ; 50Rk ; 50R ; 50D ; 50ZD) est formé de sorte que la borne de connexion (32) fasse saillie dans une direction de montage (MD) à partir d'une surface latérale d'un corps principal (31).

10. Procédé selon une ou plusieurs des revendications précédentes 7 à 9, comprenant en outre une étape de préparation d'une douille (21 ; 22 ; 23), dans laquelle au moins une DEL (10) et/ou au moins une ampoule électrique (11) peut être montée, sur le socle (20 ; 20A).
